# FASCICULE DE BREVET EUROPEEN

(11) **EP 1 247 332 B1**
(45) Date de publication et mention de la délivrance du brevet: **22.10.2003**
(21) Numéro de dépôt: 00990836.9
(22) Date de dépôt: 28.12.2000
(51) Int. Cl.: H03C 7/02

(54) **GENERATEUR D'IMPULSIONS HYPERFREQUENCES INTEGRANT UN COMPRESSEUR D'IMPULSIONS**
GENERATOR VON HOCHFREQUENZ-PULSEN UNTER VERWENDUNG EINES PULSENKOMPRESSORS
MICROWAVE PULSE GENERATOR INCORPORATING A PULSE COMPRESSOR

(30) Priorité: 30.12.1999 FR 9916776
(43) Date de publication de la demande: 09.10.2002
(73) Titulaire: THALES ELECTRON DEVICES S.A., 78140 Vélizy (FR)
(72) Inventeur: FAILLON, Georges, 94117 Arcueil Cedex (FR); DURAND, Alain-Joseph, 94117 Arcueil Cedex (FR)
(74) Mandataire: Guérin, Michel
(86) Numéro de dépôt international: FR0003721
(87) Numéro de publication internationale: WO01050592

(56) Documents cités:
- DE-B- 1 172 744
- FR-A- 2 766 272
- US-A- 2 903 652
- US-A- 3 435 342
- US-A- 4 730 169
- US-A- 5 698 949

## Description

La présente invention telle que définie dans les revendications est relative aux générateurs d'impulsions hyperfréquences capables de fournir des impulsions de puissance très élevée. Ce type de générateur a son application notamment dans le domaine des radars, des instruments scientifiques ou industriels tels que les accélérateurs d'électrons par exemple.

Dans ces domaines, on cherche parfois à obtenir des impulsions étroites de quelques nanosecondes avec une fréquence de répétition d'une ou plusieurs centaines d'Hertz. Les puissances crête de sortie sont de l'ordre du mégawatt jusqu'à la centaine de mégawatts en bande S ou en bande X. Et bien entendu on cherche à réduire au maximum l'encombrement du générateur pour que son diamètre ne dépasse pas 10 centimètres environ et sa longueur 1 mètre à 1, 5 mètre,

On se réfère à la figure 1a. Les générateurs d'impulsions hyperfréquences qui permettent de se rapprocher le plus possible des performances électriques requises comportent un magnétron 1 générant des impulsions et ce magnétron 1 coopère avec une cavité résonante de compression 2 pour comprimer l'impulsion délivrée afin d'atteindre la puissance crête et la largeur d'impulsion souhaitées. Pendant que le magnétron 1 émet une impulsion de puissance P1 et de durée t1, la cavité résonante de compression 2 est fermée, ensuite, elle est ouverte de manière à la vider rapidement en un temps t2 inférieur à t1, vers un dispositif utilisateur 9, une antenne d'émission par exemple schématisée par un cornet. La fermeture et l'ouverture se font au niveau d'une zone de la cavité référencée 6. On obtient en sortie de la cavité résonante de compression 2, aux pertes près, une impulsion de puissance P2 telle que P2.t2 ≅ P1.t1 car il y a conservation de l'énergie.

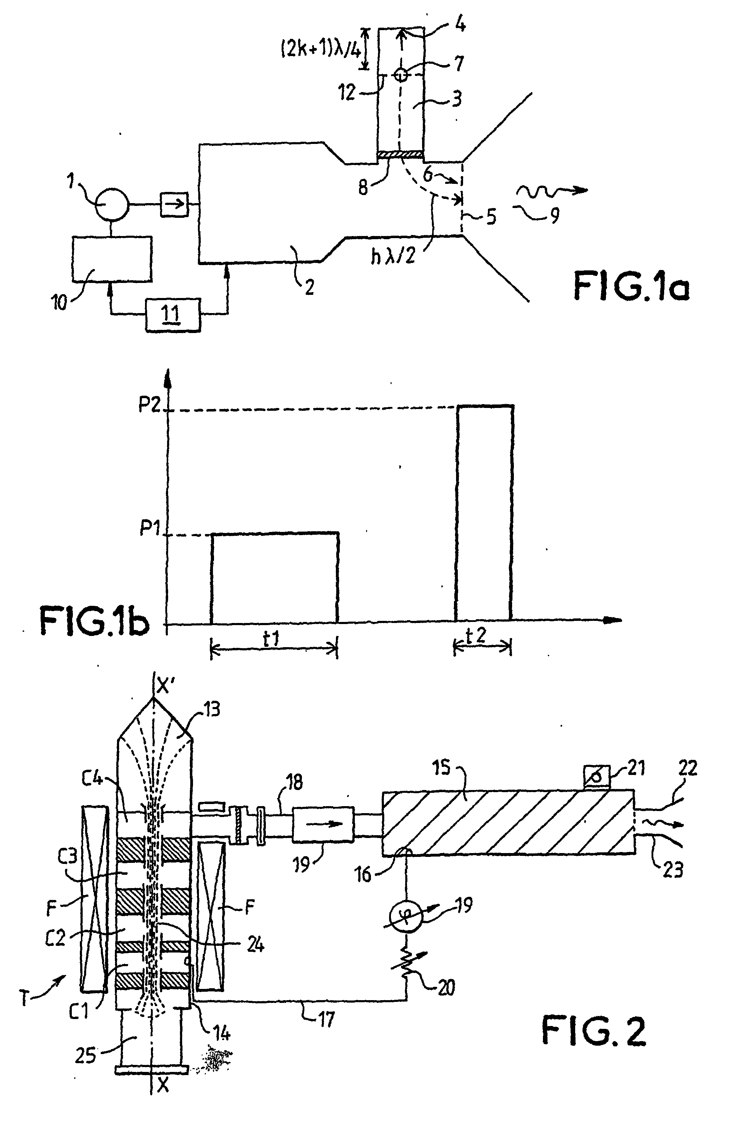

La figure 1b illustre schématiquement l'allure de l'impulsion stockée pendant le temps t1 et celle de l'impulsion libérée pendant le temps t2.

La fermeture et l'ouverture de la cavité résonnante 2 peuvent se faire par un dispositif de commutation 3 à arc électrique avec éventuellement un gaz ionisable. L'exemple de dispositif de commutation 3 représenté sur la figure 1a comporte un appendice empli d'un gaz ionisable qui est couplé à la cavité résonante de compression 2, cet appendice possède un fond 4 ayant un rôle de court-circuit. A l'opposé du fond 4, une fenêtre hyperfréquence 8 sépare l'appendice de la cavité résonante de compression 2. Le fond 4 est distant d'un multiple h de demi longueur d'onde λ/2, de l'onde stockée dans la cavité résonante de compression 2, de la zone 6 de la cavité résonnante de compression 2. Il ramène dans la zone 6, un court-circuit 5 qui ferme la cavité résonante de compression 2. Cet appendice comporte un dispositif 7 qui crée un arc électrique donc un nouveau court-circuit 12, distant d'un multiple impair (2k + 1) de quart de longueur d'onde λ/4 du fond 4. Ce court-circuit 12 ramène au niveau de la zone 6 un circuit ouvert qui ouvre la cavité vers le dispositif utilisateur 9.

La fréquence des commutations correspond à la fréquence de répétition souhaitée et elle est synchronisée avec un front de descente de l'impulsion à comprimer.

Ce type de générateur d'impulsions a pour avantage d'être simple et relativement compact mais a comme inconvénient majeur de fonctionner très mal ou pas du tout si la fréquence du magnétron 1 n'est pas égale à la fréquence de résonance de la cavité résonante de compression 2. En effet, la cavité résonante de compression 2 possède un coefficient de surtension Q très élevé, par exemple de l'ordre de 10 000, pour pouvoir emmagasiner le plus possible d'énergie. Cette valeur impose à la fréquence du magnétron, par exemple à 10 GHz, une précision meilleure que plus ou moins 0, 5 MHz. Or, après un transport, une opération de démontage-remontage, lors de variations de température, il n'est pas rare que la fréquence du magnétron se décale de plus d'un mégahertz.

La solution classique est alors d'ajouter un système de recherche 11 de la fréquence de résonance de la cavité résonnante et d'asservir le système d'accord 10 en fréquence du magnétron 1, généralement motorisé, à cette fréquence de résonance. Mais alors le générateur d'impulsions devient lourd, plus encombrant et perd de sa simplicité. Et si on ne dispose pas de système de recherche, avant chaque utilisation, un réglage doit être effectué ce qui prend du temps et qui n'est pas compatible avec l'usage que l'on veut en faire dans bien des circonstances.

La présente invention a pour but de s'affranchir de ces problèmes de réglage en fréquence et d'encombrement.

Pour y parvenir, la présente invention propose un générateur d'impulsions comportant une source hyperfréquence qui délivre un signal en impulsions dans une cavité résonante de compression équipée d'un dispositif de commutation pour l'ouvrir ou la fermer, ce signal en impulsions étant emmagasiné dans la cavité résonante de compression alors fermée pour y être comprimé avant d'être délivré avec une amplitude supérieure et une largeur inférieure lorsque la cavité est ouverte, caractérisé en ce que la source hyperfréquence est de type amplificateur avec une bande passante instantanée incluant la fréquence de résonance de la cavité résonante de compression, et en ce qu'on lui applique un signal d'entrée à amplifier qui est prélevé dans la cavité résonante de compression.

Avec une telle structure, la fréquence du signal délivré par la source hyperfréquence est bien égale à la fréquence de résonance de la cavité résonante de compression.

Comme amplificateur on peut utiliser un amplificateur à l'état solide ou un tube hyperfréquence amplificateur à interaction longitudinale.

Le dispositif de commutation peut comporter une paroi formant court-circuit qui ramène un court-circuit dans la cavité résonante de compression pour la fermer et des moyens pour déclencher un arc électrique qui ramène un circuit ouvert à la place du court-circuit pour l'ouvrir.

La paroi formant court-circuit peut être le fond d'un tronçon de guide d'onde raccordé à la cavité résonante de compression.

L'arc électrique peut s'établir dans le tronçon de guide d'onde ou bien dans la cavité résonante de compression, ce qui a pour effet de dérégler sa fréquence de résonance et de supprimer le court-circuit de fermeture.

Le dispositif de commutation peut fonctionner avec un gaz ionisable ce qui facilite l'allumage de l'arc électrique.

L'arc électrique peut s'établir au niveau de bossages ou de pointes qui ont pour effet de renforcer le champ électrique là où ils se trouvent. Il peut aussi s'établir dans un petit tube de quartz pressurisé qui canalise et optimise la décharge.

L'arc électrique peut être déclenché par un rayonnement ou peut s'autodéclencher lorsque le champ électrique est suffisamment élevé.

Lorsque la source hyperfréquence est un tube hyperfréquence, pour gagner en encombrement radial, la cavité résonante de compression peut être réalisée par son collecteur d'électrons.

Dans cette configuration, le collecteur est séparé de la cavité de sortie par une paroi comportant un orifice de passage pour les électrons et un dispositif de couplage de la cavité au collecteur qui traverse la paroi et qui est distinct de l'orifice de passage des électrons.

En vue de limiter la longueur du collecteur, il est possible d'équiper ce dernier de moyens de déflexion pour dévier les électrons de manière appropriée.

La longueur parcourue par le signal en impulsions délivré par la source hyperfréquence jusqu'à la cavité résonante de compression, dans la cavité résonante de compression puis jusqu'à la source hyperfréquence et dans la source hyperfréquence introduit, de préférence, un déphasage multiple de 2π à la fréquence de résonance de la cavité de compression, ce qui permet de transformer l'amplificateur en oscillateur.

D'autres caractéristiques et avantages de l'invention apparaîtront à la lecture de la description qui suit illustrée par les figures annexées qui représentent :
la figure 1a, déjà décrite, un générateur d'impulsions de type connu avec comme source hyperfréquence un magnétron ;
la figure 1b une représentation dans le temps de la puissance stockée dans la cavité résonante de compression de la figure 1a et de la puissance délivrée après compression ;
la figure 2 un premier exemple d'un générateur d'impulsions conforme à l'invention avec comme source hyperfréquence un tube hyperfréquence à interaction longitudinale ;
la figure 3a un second exemple de générateur d'impulsions conforme à l'invention avec comme source hyperfréquence un tube hyperfréquence à interaction longitudinale et comme cavité résonante de compression le collecteur d'électrons du tube ;
la figure 3b, en détail, les moyens pour déclencher un arc électrique dans le dispositif de commutation représenté sur la figure 3a ;
les figures 4a, 4b, 4c divers exemples de dispositifs de commutation pour ouvrir et fermer la cavité résonante de compression ;
les figures 5a, 5b deux exemples de moyens pour déclencher un arc électrique afin de dérégler la fréquence de résonance de la cavité de compression ;
la figure 6 un autre exemple d'un générateur d'impulsions conforme à l'invention avec comme source hyperfréquence un amplificateur à l'état solide.

Sur ces figures les échelles ne sont pas respectées dans un souci de clarté.

On se réfère à la figure 2 qui montre un générateur d'impulsions selon l'invention avec comme source hyperfréquence un tube T hyperfréquence amplificateur à interaction longitudinale dit aussi de type "O". Sur la figure il s'agit d'un klystron. On pourrait le remplacer par un tube à ondes progressives ou tout dérivé des klystrons ou des tubes à ondes progressives. Ce tube est classique et comporte un canon 25 produisant un faisceau d'électrons 24 long et fin d'axe XX'. Le faisceau d'électrons 24 traverse une succession de cavités C1 à C4. Les cavités C1 à C4 sont entourées d'un dispositif de focalisation F. La cavité C1, la plus proche du canon 25 est dite cavité d'entrée. La cavité C4, la plus éloignée du canon 25 est dite cavité de sortie. Les électrons du faisceau 24 après avoir traversé la cavité de sortie C4 sont recueillis dans un collecteur 13. Un signal à amplifier est introduit dans la cavité d'entrée C1 à l'aide d'un dispositif de couplage 14. Il va interagir avec les électrons qui vont lui céder une partie de leur énergie. Le signal après amplification est extrait de la cavité de sortie C4 et est injecté dans une cavité résonante de compression 15.

Selon une caractéristique du générateur d'impulsions selon l'invention, le signal introduit à l'entrée est prélevé dans la cavité résonante de compression 15. On a représenté à cet effet des moyens pour prélever l'énergie dans la cavité résonante de compression 15, pour l'acheminer jusqu'à l'entrée avec: un dispositif de couplage 16, par exemple de type boucle dans la cavité résonante de compression 15 et une ligne de transmission 17 entre le dispositif de couplage 16 qui plonge dans la cavité résonante de compression 15 et le dispositif de couplage 14 qui plonge dans la cavité d'entrée C1.

La cavité résonante de compression 15 est équipée d'un dispositif de commutation 21 qui peut être de même nature que celui décrit à la figure 1a. Son fonctionnement est le suivant : on ferme la cavité résonante de compression 15 par la création d'un court-circuit pendant que l'on stocke l'énergie pour la comprimer, puis on ouvre la cavité résonante de compression 15 par la création d'un arc électrique correctement positionné qui transforme le court-circuit en un circuit ouvert.

La cavité résonante de compression 15 est reliée directement ou non à un dispositif utilisateur 22, une antenne par exemple, à proximité du dispositif de commutation 21. Si cette liaison n'est pas directe, une ligne de transmission 23 sert d'intermédiaire entre la cavité résonante de compression 15 et le dispositif utilisateur 22.

La cavité résonante de compression 15 est reliée à la cavité de sortie C4 par une ligne de transmission 18, par exemple de type guide d'onde. Il est préférable mais non strictement nécessaire de prévoir sur cette ligne de transmission 18 un isolateur 19, par exemple à ferrite, pour éviter des réflexions d'ondes de la cavité résonante de compression 15 vers le tube hyperfréquence T.

Le fait de prélever le signal d'entrée dans la cavité résonante de compression 15 qui possède un fort coefficient de surtension et dont la fréquence de résonance est parfaitement définie par ses dimensions, impose que la fréquence du signal délivrée par la source hyperfréquence coïncide avec celle de la cavité résonante de compression. Il suffit que la bande passante instantanée de la source hyperfréquence englobe la fréquence de résonance. Pour optimiser notamment en gain les performances du tube hyperfréquence, il est possible d'introduire sur le chemin entre la cavité résonante de compression 15 et la cavité d'entrée C1, un dispositif de déphasage 19 et/ou un dispositif atténuateur 20.

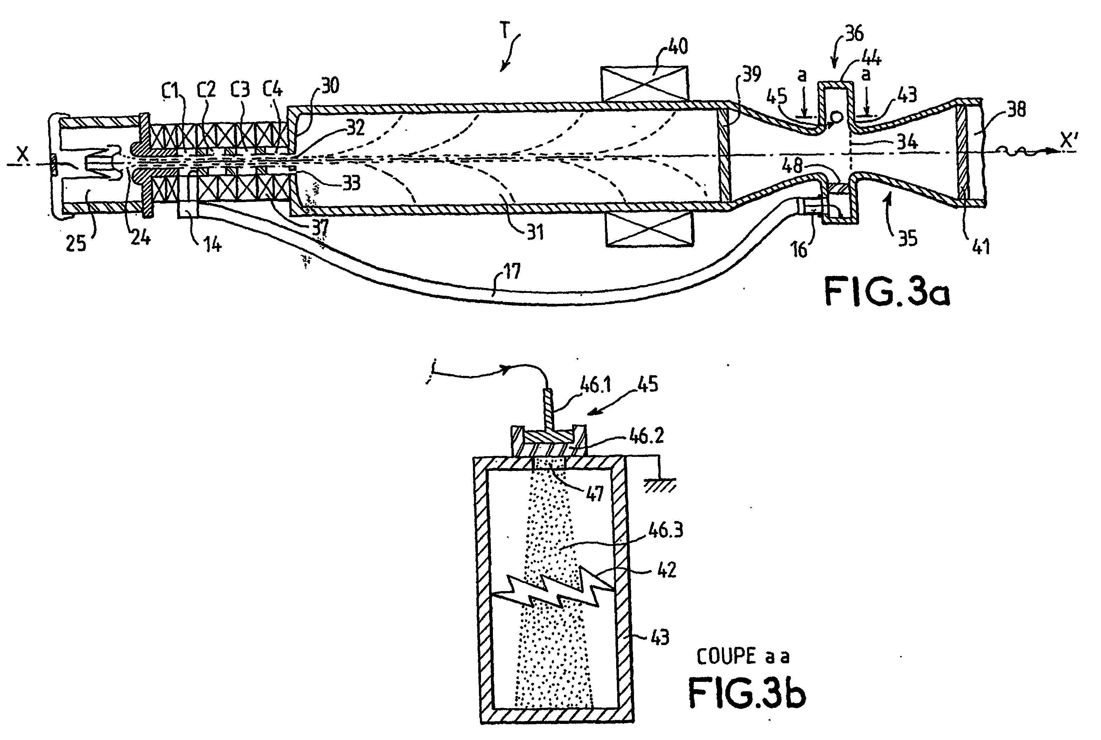

On aurait pu envisager que la longueur électrique de la boucle fermée formée par la source hyperfréquence T, par la ligne de transmission 18 qui relie la source hyperfréquence T à la cavité résonante de compression 15, par la cavité résonante de compression 15, par la ligne de transmission 17 qui relie la cavité résonante de compression 15 à la source hyperfréquence T introduise un déphasage multiple de 2π, à la fréquence de fonctionnement qui est la fréquence de résonance de la cavité résonante de compression, de manière que cet ensemble se comporte en oscillateur autonome à cette même fréquence. On suppose que sur la figure 3a c'est le cas.

De manière à gagner encore plus en encombrement radial, il est possible que ce soit le collecteur 13 du tube T hyperfréquence à interaction longitudinale qui serve de cavité résonante de compression. Cette variante est représentée sur la figure 3a. Le tube T hyperfréquence dans sa partie qui va du canon 25 à l'avant dernière cavité C3 est comparable à celui représenté à la figure 2, à l'exception du dispositif de focalisation qui a été adapté pour réduire encore l'encombrement radial, mais qui aurait pu être conservé.

La cavité de sortie C4 située en amont du collecteur 31 en est séparée par une paroi terminale 30 dotée d'un orifice de passage 32 pour les électrons. Ces éléments n'étaient pas référencés sur la figure 2. Par contre maintenant le collecteur 31 et la cavité de sortie C4 sont couplés électromagnétiquement l'un à l'autre à l'aide d'un organe de couplage 33 qui traverse la paroi terminale 30 et est représenté comme un iris. L'orifice de passage 32 pour les électrons se trouve dans la partie centrale de la paroi 30, calé sur l'axe XX' du faisceau 24 d'électrons tandis que l'iris 33 est décalé par rapport à l'axe XX'.

Le signal hyperfréquence en impulsions provenant de la cavité de sortie C4 se propage dans le collecteur 31 où d'une part il cohabite avec les électrons du faisceau 24 et d'autre part il est stocké pour y être comprimé. La sortie 35 du collecteur 31 est située à l'opposé de la paroi terminale 30, et cette sortie se fait de préférence longitudinalement pour réduire l'encombrement radial. Le collecteur 31 est équipé du dispositif de commutation 36 dont le rôle est d'assurer sa fermeture, au sens hyperfréquence du terme, pendant la phase de compression du signal en impulsions et son ouverture lors de son extraction.

De manière à conserver un encombrement radial aussi réduit que possible, le dispositif de focalisation F du tube T qui était extérieur sur la figure 2 a été remplacé par un dispositif 37 plus compact logé entre les cavités C1 à C4. Il est formé d'aimants annulaires. Ce dispositif est connu sous la dénomination de structure à aimants permanents périodiques ou sous la dénomination anglo-saxonne "ppm" pour "periodic permanent magnets".

Le collecteur 31 sera aisément refroidi par rayonnement et convection extérieure car la puissance moyenne à évacuer sera relativement faible. Avec une puissance crête hyperfréquence de 1MW et un rendement de 40%, la puissance à dissiper dans le collecteur est de l'ordre de 1,75kW avec des impulsions en entrée de 7 microsecondes et en sortie de 7 nanosecondes à la cadence de 100Hz. Or un collecteur cylindrique de 75 millimètres de diamètre et de longueur de plusieurs dizaines de centimètres correspond au pire à 10W/Cm². L'évacuation d'une telle densité de puissance ne pose pas de problème particulier.

Le tube T hyperfréquence travaille sous vide et le dispositif utilisateur 38 auquel il est relié fonctionne à une pression différente, par exemple la pression atmosphérique ou une pression supérieure. On prévoit au moins une fenêtre 39 entre la cavité de sortie C4 et le dispositif utilisateur 38. Cette fenêtre 39 sera disposée le plus loin possible de la cavité de sortie C4 de manière à être la moins exposée possible aux électrons du faisceau 24 qui se dispersent dans le collecteur 31. Sur la figure 3a, la fenêtre 39 est placée en bout de collecteur 31 juste avant le dispositif de commutation 36. La longueur du collecteur 31 est adaptée pour qu'il puisse accumuler toute l'énergie hyperfréquence voulue.

On peut également réduire le bombardement électronique de la fenêtre 39 en plaçant à l'extérieur du collecteur 31 des moyens de déflexion 40 pour dévier les électrons du faisceau vers les parois du collecteur 31 avant qu'ils n'atteignent la fenêtre. Ces moyens de déflexion 40 peuvent être réalisés par un ou plusieurs aimants à aimantation radiale.

On peut prévoir une seconde fenêtre 41 placée entre le dispositif de commutation 36 et le dispositif utilisateur 38 si le dispositif de commutation 36 fonctionne avec une atmosphère différente de celle du dispositif utilisateur 38. On a même ajouté une troisième fenêtre 48 pour isoler le dispositif de commutation 36 des moyens pour prélever l'énergie dans le collecteur 31 (décrits ultérieurement).

On va voir maintenant divers modes de réalisation du dispositif de commutation 36. La fréquence des commutations correspond à la fréquence de répétition souhaitée et elle est, de préférence, synchronisée avec un front de descente de l'impulsion à comprimer.

Dans une première variante représentée à la figure 3a, il s'agit d'un dispositif à gaz ionisable comme celui décrit à la figure 1. L'appendice contenant le gaz ionisable est un tronçon de guide d'onde 43 raccordé au collecteur 31. Son fond 44 ramène le court-circuit 34 à un nombre entier de demie longueur d'onde dans le collecteur 31 pour le fermer. Il contient des moyens 45 pour déclencher l'arc électrique 42 dans le gaz ionisé et ces moyens sont extérieurs au tronçon de guide d'onde. Le gaz ionisable peut être de l'hexafluorure de soufre. Cet arc électrique 42 s'établit entre deux parois du tronçon de guide d'onde 43 et est équivalent à un court-circuit. Cet arc électrique 42 s'établit à un nombre impair de quart de longueur d'onde du fond 44 pour ramener à la place du court-circuit 34 un circuit ouvert.

Les moyens 45 pour déclencher l'arc électrique ont été schématisés sur la figure 3a par un cercle mais on se réfère à la figure 3b pour les décrire en détails. La vue dé la figure 3b est une coupe transversale du tronçon de guide d'onde 43 selon la ligne a-a. Le déclenchement de l'arc se fait par l'émission d'un rayonnement qui provoque l'ionisation du gaz et très vite l'allumage de l'arc 42 au niveau du rayonnement. Sur les figures 3a, 3b, les moyens 45 pour déclencher l'arc électrique 42 sont formés d'un émetteur de rayonnement ultraviolet 46.3. Le rayonnement ultraviolet 46.3 est émis latéralement dans le tronçon de guide d'onde 43 et l'arc électrique 42 se déclenche transversalement au rayonnement ultraviolet 46.3. Cet arc électrique 42 correspond à une décharge de la composante de champ électrique de l'onde électromagnétique emmagasinée. Cet arc électrique 42 constitue le court-circuit recherché pour ouvrir le collecteur 31. L'émetteur de rayonnement peut comporter une électrode 46.1 que l'on relie à un générateur électrique (non représenté) délivrant une haute tension pulsée et une pastille de céramique 46.2 maintenue en sandwich entre une paroi du tronçon de guide d'onde 43 et l'électrode 46.1. La paroi du tronçon de guide d'onde 43 comporte une ouverture obturée par une fenêtre 47 transparente aux ultraviolets pour laisser pénétrer le rayonnement ultraviolet 46.3 dans le tronçon de guide d'onde 43. Lorsque l'électrode 46.1 est alimentée, la pastille de céramique 46.2 se trouve d'un côté portée au potentiel de l'électrode 46.1 et de l'autre au potentiel de la paroi du tronçon de guide d'onde, ces potentiels étant différents, il se produit un claquage de la pastille de céramique 46.2 et une émission d'ultraviolet 46.3.

Les dimensions du tronçon de guide d'onde 43 sont adaptées au mode hyperfréquence présent dans le collecteur 31. La géométrie de la sortie 35 du collecteur 31 est choisie pour obtenir lors de l'ouverture, la surtension voulue en relation avec la largeur t2 de l'impulsion délivrée. A cet effet, la section droite du collecteur a été réduite sur les figures.

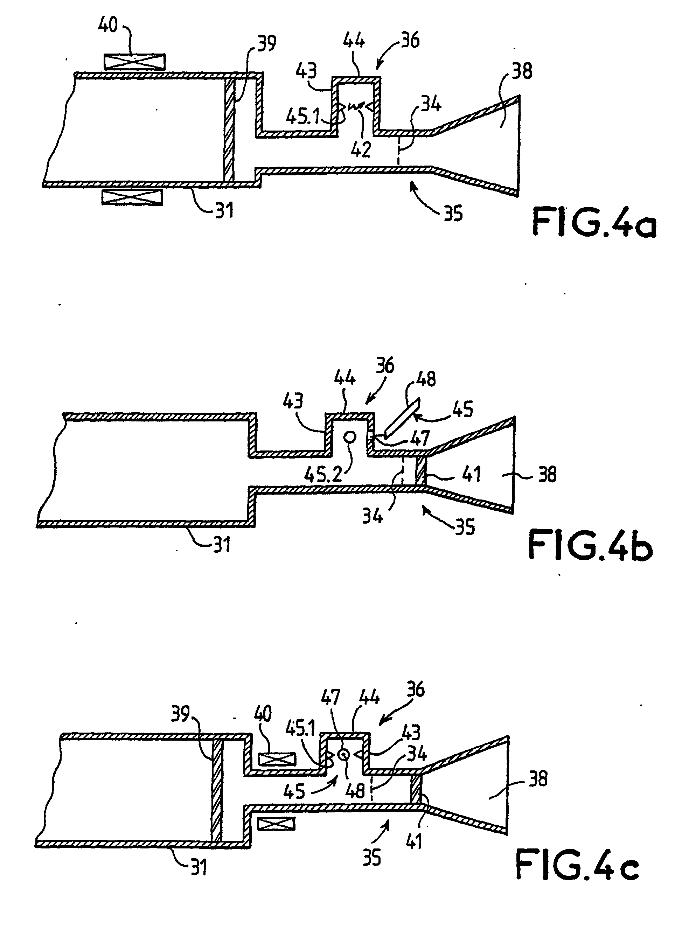

Au lieu d'utiliser un dispositif de commutation à gaz ionisable, il est possible d'en utiliser un qui fonctionne dans le vide comme le collecteur comme le montre la figure 4b ou un qui fonctionne dans la même atmosphère que le dispositif utilisateur ainsi que le montre la figure 4a. Il suffit de bien positionner le dispositif de commutation 36 par rapport à une ou plusieurs fenêtres.

Au lieu de déclencher l'arc électrique 42 par le rayonnement ultraviolet comme le montre la figure 3a, il est possible d'utiliser un rayonnement d'une autre nature, délivré par un laser 48 par exemple, à travers une fenêtre 47 pour ioniser le gaz (figure 4b, figure 4c).

A l'endroit où l'arc électrique 42 va s'établir, le tronçon de guide d'onde 43 peut comporter intérieurement des bossages ou pointes 45.1 pour renforcer le champ électrique, ce qui facilite l'allumage de l'arc 42 (figure 4a, figure 4c).

L'arc électrique peut s'établir dans un petit tube de quartz 45.2 pressurisé spécialement, disposé dans le tronçon de guide d'onde 43, cet arc étant déclenché par un rayonnement délivré par un laser 48 par exemple (figure 4b).

D'autres moyens sont bien sûr envisageables pour engendrer l'arc électrique sans sortie du cadre de l'invention et notamment l'arc électrique 42 peut s'autodéclencher lorsque le champ électrique est suffisamment élevé (figure 4a). Dans cette variante l'arc électrique 42 s'établit entre les deux bossages 45.1 qui permettent de le positionner.

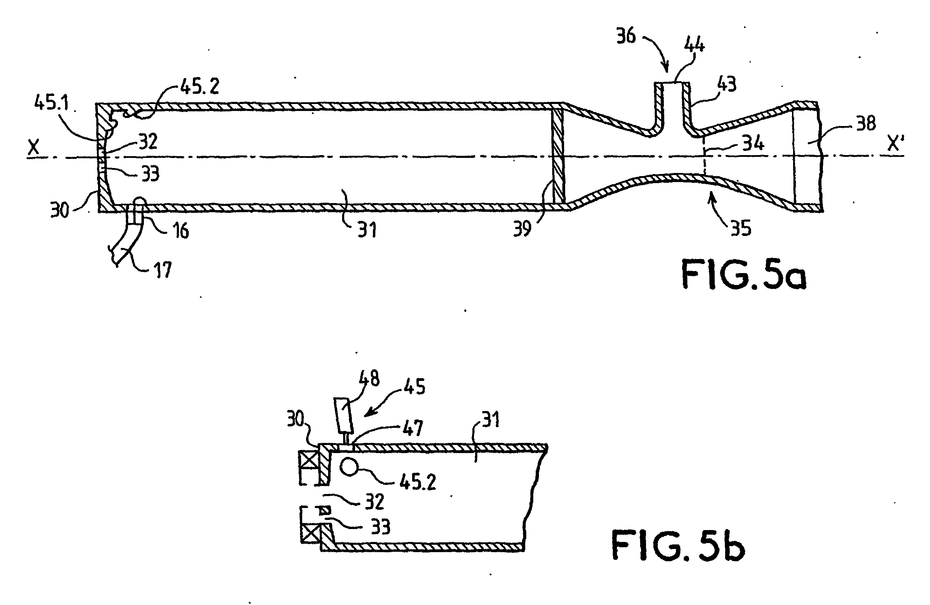

Au lieu que l'arc électrique soit allumé dans le tronçon de guide d'onde 43 dont le fond 44 ramène un court-circuit 34 qui ferme le collecteur 31, il est possible de l'allumer à certains endroits jugés appropriés du collecteur 31 en fonction du mode hyperfréquence qui s'y trouve et de la trajectoire des électrons. Ces endroits sont tels que l'arc électrique 42 qui y prend naissance dérègle la fréquence de résonance dans le collecteur 31 et supprime le court-circuit de fermeture 34, le collecteur 31 se transforme alors en un circuit ouvert. Cette variante est illustrée aux figures 5a et 5b. Sur la figure 5a, par autoallumage l'arc électrique 42 s'établit entre deux parois du collecteur 31, placées sensiblement à angle droit l'une de l'autre, l'une des parois étant la paroi 30 qui sépare le collecteur 31 de la cavité de sortie C4. Sur la figure 5b, on a placé sensiblement au même endroit un tube de quartz 45.2 pressurisé analogue à celui de la figure 4b. Le tronçon de guide d'onde 43 est conservé, son fond 44 créant le court-circuit 34 de fermeture.

Tout ce qui a été décrit pour fermer et ouvrir le collecteur peut très bien s'appliquer au cas où l'énergie hyperfréquence est comprimée dans une cavité résonante de compression distincte du collecteur.

Les moyens pour prélever de l'énergie dans le collecteur 31 et pour la transporter en vue de son injection à l'entrée du tube T sont représentés sous la forme de deux boucles 14 et 16, l'une 16 qui plonge dans le collecteur 31 et l'autre 14 qui plonge dans la cavité d'entrée C1 et ces deux boucles 14, 16 sont reliées entre elles par une ligne de transmission 17. Les moyens pour prélever l'énergie dans le collecteur seront placés, de préférence, à un endroit où ils apportent le moins de perturbation possible. Sur la figure 3a, on les voit au niveau du dispositif de commutation 36 et sur la figure 5a dans le collecteur 31 à proximité de la cavité de sortie C4.

Avec une telle structure, un générateur d'impulsions incluant un klystron de puissance de 50 à 100kW crête en bande X, ayant les performances électriques requises pourra avoir une longueur d'au maximum 80 centimètres pour un diamètre d'au maximum 10 centimètres.

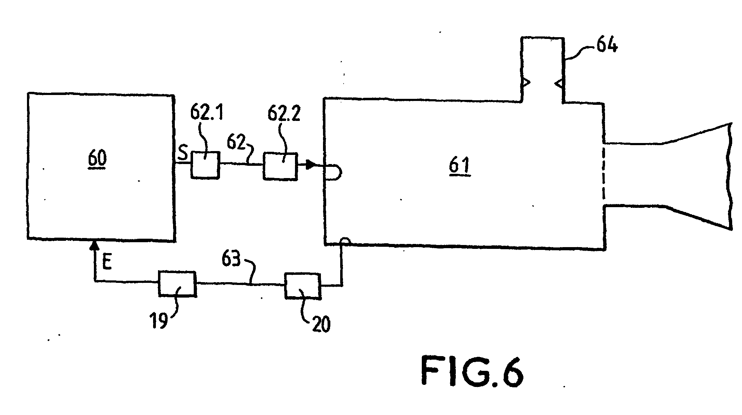

Au lieu que l'amplificateur soit un amplificateur à tube, il peut être un amplificateur 60 à l'état solide, c'est ce qu'illustre la figure 6. Sa sortie S délivre un signal injecté dans la cavité résonante de compression 61. Une ligne de transmission 62 la transporte depuis l'amplificateur 60 jusqu'à la cavité résonante de compression 61. De l'énergie est prélevée dans la cavité résonante de compression 61 pour l'injecter à l'entrée E de l'amplificateur 60. Une autre ligne 63 de transmission la transporte depuis la cavité résonante de compression 61 jusqu'à l'entrée E de l'amplificateur 60. La cavité de compression 61 est couplée au dispositif de commutation 64 qui peut prendre l'une des réalisations décrites précédemment. La ligne de transmission 62 peut éventuellement comporter un dispositif d'atténuation 62.1 et/ou un isolateur 62.2 à des fins de bonne adaptation et de protection. La ligne 63 peut éventuellement comporter comme en figure 2 un dispositif de déphasage 19 et/ou un dispositif d'atténuation 20.

## Revendications

1. Générateur d'impulsions comportant une source hyperfréquence (T, 60) qui délivre un signal en impulsions dans une cavité résonante (15) de compression équipée d'un dispositif de commutation (21) pour l'ouvrir ou la fermer, ce signal en impulsions étant emmagasiné dans la cavité résonante (15) de compression alors fermée pour y être comprimé avant d'être délivré avec une amplitude supérieure et une largeur inférieure lorsque la cavité résonante de compression (15) est ouverte, **caractérisé en ce que** la source hyperfréquence (T) est de type amplificateur avec une bande passante instantanée incluant la fréquence de résonance de la cavité résonante de compression, et **en ce qu'**elle reçoit en entrée (C1) un signal d'entrée à amplifier qui est prélevé dans la cavité résonante de compression (15).

2. Générateur d'impulsions selon la revendication 1, **caractérisé en ce que** la source hyperfréquence est un amplificateur (60) à l'état solide.

3. Générateur d'impulsions selon la revendication 1, **caractérisé en ce que** la source hyperfréquence est un tube (T) hyperfréquence amplificateur à interaction longitudinale.

4. Générateur d'impulsions selon l'une des revendications 1 à 3, **caractérisé en ce que** le dispositif de commutation (36) comporte une paroi (44) formant court-circuit qui ramène un court-circuit (34) dans la cavité résonante (31) de compression pour la fermer et des moyens (45) pour déclencher un arc électrique (42) qui ramène un circuit ouvert à la place du court-circuit (34) pour l'ouvrir.

5. Générateur d'impulsions selon la revendication 4, **caractérisé en ce que** la paroi (44) formant court-circuit est le fond d'un tronçon de guide d'onde (43) raccordé à la cavité résonante de compression (31).

6. Générateur d'impulsions selon la revendication 5, **caractérisé en ce que** l'arc électrique (42) s'établit dans le tronçon de guide d'onde (43).

7. Générateur d'impulsions selon l'une des revendications 4 ou 5, **caractérisé en ce que** l'arc électrique (42) s'établit dans la cavité résonante de compression (31), ce qui a pour effet de dérégler sa fréquence de résonance.

8. Générateur d'impulsions selon l'une des revendications 4 à 7, **caractérisé en ce que** le dispositif de commutation (36) fonctionne avec un gaz ionisable.

9. Générateur d'impulsions selon l'une des revendications 4 à 8, **caractérisé en ce que** l'arc électrique (42) s'établit entre deux bossages (45.1) en vis à vis.

10. Générateur d'impulsions selon l'une des revendications 4 à 8, **caractérisé en ce que** l'arc électrique (42) s'établit dans un tube de quartz (45.2) pressurisé.

11. Générateur d'impulsions selon l'une des revendications 4 à 10, **caractérisé en ce que** les moyens (45) pour déclencher l'arc électrique (42) délivrent un rayonnement (46.3).

12. Générateur d'impulsions selon l'une des revendications 4 à 9, **caractérisé en ce que** l'arc électrique (42) s'autodéclenche.

13. Générateur d'impulsions selon l'une des revendications 3 à 12, dans lequel le tube hyperfréquence (T) comporte un collecteur d'électrons (31), **caractérisé en ce que** la cavité résonante de compression est réalisée par le collecteur.

14. Générateur d'impulsions selon la revendication 13, dans lequel le tube hyperfréquence comporte en amont du collecteur (31) une cavité de sortie (C4), **caractérisé en ce que** le collecteur (31) est séparé de la cavité de sortie (C4) par une paroi (30) comportant un orifice (32) de passage pour les électrons et un dispositif de couplage (34) de la cavité de sortie (C4) au collecteur (31) qui traverse la paroi (30) et qui est distinct de l'orifice (32) de passage des électrons.

15. Générateur d'impulsions selon l'une des revendications 13 ou 14, **caractérisé en ce que** le collecteur (31) est équipé de moyens de déflexion (40) pour dévier les électrons.

16. Générateur d'impulsions selon l'une des revendications 1 à 15, **caractérisé en ce qu'**il comporte entre la cavité résonante de compression (31) et la source hyperfréquence (T), des moyens (14, 16, 17) pour prélever le signal d'entrée à amplifier dans la cavité résonante de compression et l'injecter à l'entrée (C1) de la source hyperfréquence (T).

17. Générateur d'impulsions selon la revendication 16, **caractérisé en ce que** les moyens (14, 16, 17) pour prélever le signal d'entrée à amplifier dans la cavité résonante de compression et l'injecter à l'entrée (C1) de la source hyperfréquence (T) comportent un dispositif de déphasage (19) et/ou un dispositif atténuateur (20).

18. Générateur d'impulsions selon l'une des revendications 1 à 17, **caractérisé en ce que** la longueur parcourue par le signal en impulsions délivré par la source hyperfréquence (T) jusqu'à la cavité de compression (31), dans la cavité résonante de compression (31), jusqu'à la source hyperfréquence (T) et dans la source hyperfréquence (T) introduit un déphasage multiple de 2π à la fréquence de résonance de la cavité de compression (31).

## Patentansprüche

1. Impulsgenerator, der eine Höchstfrequenzquelle (T, 60) umfaßt, die in einen Kompressions-Resonanzhohlraum (15), der mit einer Schaltvorrichtung (21) ausgerüstet ist, um ihn zu öffnen oder zu schließen, ein Impulssignal liefert, das in dem dann geschlossenen Kompressions-Resonanzhohlraum (15) gespeichert wird, um hier komprimiert zu werden, bevor es mit einer größeren Amplitude und einer kleineren Breite als bei offenem Kompressions-Resonanzhohlraum (15) ausgegeben wird, **dadurch gekennzeichnet, daß** die Höchstfrequenzquelle (T) vom Typ Verstärker mit einem momentanen Durchlaßband, das die Resonanzfrequenz des Kompressions-Resonanzhohlraums enthält, ist und daß sie am Eingang (C1) ein zu verstärkendes Eingangssignal empfängt, das in dem Kompressions-Resonanzhohlraum (15) entnommen wird.

2. Impulsgenerator nach Anspruch 1, **dadurch gekennzeichnet, daß** die Höchstfrequenzquelle ein Festkörper-Verstärker (60) ist.

3. Impulsgenerator nach Anspruch 1, **dadurch gekennzeichnet, daß** die Höchstfrequenzquelle eine Höchstfrequenz-Verstärkerröhre (T) mit longitudinaler Wechselwirkung ist.

4. Impulsgenerator nach einem der Ansprüche 1 bis 3, **dadurch gekennzeichnet, daß** die Schaltvorrichtung (36) eine einen Kurzschluß bildende Wand (44) aufweist, die einen Kurzschluß (34) in dem Kompressions-Resonanzhohlraum (31) anlegt, um ihn zu schließen, und Mittel (45) aufweist, die einen Lichtbogen (42) auslösen, der am Ort des Kurzschlusses (34) einen offenen Kreis bildet, um ihn zu öffnen.

5. Impulsgenerator nach Anspruch 4, **dadurch gekennzeichnet, daß** die einen Kurzschluß bildende Wand (44) der Boden eines Wellenleiterteilstücks (43) ist, das mit dem Kompressions-Resonanzhohlraum (31) verbunden ist.

6. Impulsgenerator nach Anspruch 5, **dadurch gekennzeichnet, daß** sich der Lichtbogen (42) in dem Wellenleiterteilstück (43) aufbaut.

7. Impulsgenerator nach einem der Ansprüche 4 oder 5, **dadurch gekennzeichnet, daß** sich der Lichtbogen (42) in dem Kompressions-Resonanzhohlraum (31) aufbaut, was die Wirkung hat, daß dessen Resonanzfrequenz verstellt wird.

8. Impulsgenerator nach einem der Ansprüche 4 bis 7, **dadurch gekennzeichnet, daß** die Schaltvorrichtung (36) mit einem ionisierbaren Gas arbeitet.

9. Impulsgenerator nach einem der Ansprüche 4 bis 8, **dadurch gekennzeichnet, daß** sich der Lichtbogen (42) zwischen zwei gegenüberliegenden Höckern (45.1) aufbaut.

10. Impulsgenerator nach einem der Ansprüche 4 bis 8, **dadurch gekennzeichnet, daß** sich der Lichtbogen (42) in einer mit Druck beaufschlagten Quarzröhre (45.2) aufbaut.

11. Impulsgenerator nach einem der Ansprüche 4 bis 10, **dadurch gekennzeichnet, daß** die Mittel (45), die den Lichtbogen (42) auslösen, eine Strahlung (46.3) abgeben.

12. Impulsgenerator nach einem der Ansprüche 4 bis 9, **dadurch gekennzeichnet, daß** sich der Lichtbogen (42) von selbst auslöst.

13. Impulsgenerator nach einem der Ansprüche 3 bis 12, bei dem die Höchstfrequenzröhre (T) einen Elektronenkollektor (31) aufweist, **dadurch gekennzeichnet, daß** der Kompressions-Resonanzhohlraum durch den Kollektor verwirklicht ist.

14. Impulsgenerator nach Anspruch 13, bei dem die Höchstfrequenzröhre auf der Einlaßseite des Kollektors (31) einen Ausgangshohlraum (C4) aufweist, **dadurch gekennzeichnet, daß** der Kollektor (31) von dem Ausgangshohlraum (C4) durch eine Wand (30) getrennt ist, die eine Durchgangsöffnung (32) für Elektronen und eine Kopplungsvorrichtung (34) zwischen dem Ausgangshohlraum (C4) und dem Kollektor (31), die durch die Wand (30) verläuft und von der Durchgangsöffnung (32) für Elektronen verschieden ist, aufweist.

15. Impulsgenerator nach einem der Ansprüche 13 oder 14, **dadurch gekennzeichnet, daß** der Kollektor (31) mit Ablenkmitteln (40) zum Ablenken von Elektronen versehen ist.

16. Impulsgenerator nach einem der Ansprüche 1 bis 15, **dadurch gekennzeichnet, daß** er zwischen dem Kompressions-Resonanzhohlraum (31) und der Höchstfrequenzquelle (T) Mittel (14, 16, 17) aufweist, die das in dem Kompressions-Resonanzhohlraum zu verstärkende Eingangssignal entnehmen und in den Eingang (C1) der Höchstfrequenzquelle (T) einleiten.

17. Impulsgenerator nach Anspruch 16, **dadurch gekennzeichnet, daß** die Mittel (14, 16, 17) zum Entnehmen des in dem Kompressions-Resonanzhohlraum zu verstärkenden und in den Eingang (C1) der Höchstfrequenzquelle (T) einzuleitenden Eingangssignals eine Phasenverschiebungsvorrichtung (19) und/oder eine Dämpfungsvorrichtung (20) umfassen.

18. Impulsgenerator nach einem der Ansprüche 1 bis 17, **dadurch gekennzeichnet, daß** die Länge, die von dem von der Höchstfrequenzquelle (T) gelieferten Impulssignal bis zum Kompressionshohlraum (31), in dem Kompressions-Resonanzhohlraum (31), bis zur Höchstfrequenzquelle (T) sowie in der Höchstfrequenzquelle (T) durchlaufen wird, in die Resonanzfrequenz des Kompressionshohlraums (31) eine Phasenverschiebung, die ein Vielfaches von 2π ist, einführt.

## Claims

1. Pulse generator comprising a microwave source (T, 60) which delivers a pulsed signal into a resonant compression cavity (15) equipped with a switching device (21) for opening it or closing it, this pulsed signal being stored in the resonant compression cavity (15) when closed in order to be compressed therein before being delivered with a greater amplitude and a smaller width when the resonant compression cavity (15) is open, **characterized in that** the microwave source (T) is of the amplifier type with an instantaneous bandwidth including the resonant frequency of the resonant compression cavity, and **in that** it is fed at the input (C1) with an input signal to be amplified which is taken off from the resonant compression cavity (15).

2. Pulse generator according to Claim 1, **characterized in that** the microwave source is a solid-state amplifier (60).

3. Pulse generator according to Claim 1, **characterized in that** the microwave source is a longitudinal interaction microwave amplifier tube (T).

4. Pulse generator according to one of Claims 1 to 3, **characterized in that** the switching device (36) comprises a wall (44) forming a short circuit which restores a short circuit (34) in the resonant compression cavity (31) in order to close it and means (45) to strike an electric arc (42) which restores an open circuit in place of the short circuit (34) in order to open it.

5. Pulse generator according to Claim 4, **characterized in that** the wall (44) forming a short circuit is the bottom of a waveguide portion (43) connected to the resonant compression cavity (31).

6. Pulse generator according to Claim 5, **characterized in that** the electric arc (42) is set up in the waveguide portion (43).

7. Pulse generator according to either of Claims 4 and 5, **characterized in that** the electric arc (42) is set up in the resonant compression cavity (31), which has the effect of changing its resonant frequency.

8. Pulse generator according to one of Claims 4 to 7, **characterized in that** the switching device (36) operates with an ionizable gas.

9. Pulse generator according to one of Claims 4 to 8, **characterized in that** the electric arc (42) is set up between two facing bosses (45.1).

10. Pulse generator according to one of Claims 4 to 8, **characterized in that** the electric arc (42) is set up in a pressurized quartz tube (45.2).

11. Pulse generator according to one of Claims 4 to 10, **characterized in that** the means (45) to strike the electric arc (42) release radiation (46.3).

12. Pulse generator according to one of Claims 4 to 9, **characterized in that** the electric arc (42) strikes automatically.

13. Pulse generator according to one of Claims 3 to 12, in which the microwave tube (T) comprises an electron collector (31), **characterized in that** the resonant compression cavity is made by the collector.

14. Pulse generator according to Claim 13, in which the microwave tube comprises, upstream from the collector (31), an output cavity (C4), **characterized in that** the collector (31) is separated from the output cavity (C4) by a wall (30) comprising a through-orifice (32) for the electrons and a device (34) for coupling the output cavity (C4) to the collector (31) which passes through the wall (30) and which is distinct from the through-orifice (32) for the electrons.

15. Pulse generator according to either of Claims 13 and 14, **characterized in that** the collector (31) is equipped with deflection means (40) in order to deflect the electrons.

16. Pulse generator according to one of Claims 1 to 15, **characterized in that** it comprises, between the resonant compression cavity (31) and the microwave source (T), means (14, 16, 17) for taking off the input signal to be amplified from the resonant compression cavity and injecting it at the input (C1) of the microwave source (T).

17. Pulse generator according to Claim 16, **characterized in that** the means (14, 16, 17) for taking off the input signal to be amplified from the resonant compression cavity and injecting it at the input (C1) of the microwave source (T) comprise a phase-shifting device (19) and/or an attenuating device (20).

18. Pulse generator according to one of Claims 1 to 17, **characterized in that** the length travelled by the pulsed signal delivered by the microwave source (T) up to the compression cavity (31), in the resonant compression cavity (31) up to the microwave source (T) and in the microwave source (T) introduces a phase shift which is a multiple of 2π at the resonant frequency of the compression cavity (31).
